# EUROPÄISCHE PATENTSCHRIFT

(11) **EP 0 387 749 B1**
(45) Veröffentlichungstag und Bekanntmachung des Hinweises auf die Patenterteilung: **10.05.1995**
(21) Anmeldenummer: 90104622.7
(22) Anmeldetag: 12.03.1990
(51) Int. Cl.: H05K 7/14, G05F 1/595, H05K 7/02

(54) **Einschubeinheitenträger**
Holder of slide-in units
Support d'unités de tiroir

(30) Priorität: 13.03.1989 DE 8903083 U
(43) Veröffentlichungstag der Anmeldung: 19.09.1990
(73) Patentinhaber: FORCE COMPUTERS GMBH, D-85579 Neubiberg (DE)
(72) Erfinder: Skordou, Evangelos, D-8059 Langenpreising (DE); Hofmann, Stefan, D-8035 Gauting (DE)
(74) Vertreter: Patentanwälte Dipl.-Ing. R. Splanemann Dr. B. Reitzner Dipl.-Ing. K. Baronetzky

(56) Entgegenhaltungen:
- EP-A- 0 207 496
- FR-A- 2 548 403
- US-A- 4 697 858

## Beschreibung

Die Erfindung betrifft einen Einschubeinheitenträger, gemäß dem Oberbegriff von Anspruch 1. Ein derartiger Einschubeinheitenträger ist aus EP-A-0 207 496 bekannt.

Bei derartigen Einschubeinheitenträgern wird eine Mutterplatine (ein sog. Motherboard), das für den Anschluß und die elektrische Verbindung einer Mehrzahl von Einschubeinheiten dient, über einen Netzteil-Einschub versorgt, der auf der Rückseite des Motherboards, bezogen auf die Einschubeinheiten, angebracht ist.

Der Netzteil-Einschub kann dann in verschiedenen Leistungsstärken, entsprechend verschiedenen Ausbaustufen des Einschubeinheitenträgers, bereitgestellt werden.

Digitalschaltungen, wie beispielsweise Computer, benötigen eine stabile Spannungsversorgung mit ausreichender Strombelastbarkeit. Andererseits neigen Logikschaltungen in der sog. TTL-Technik dazu, die Spannungsversorgungsleitungen kurzzeitig intensiv zu belasten, was zu unerwünschten Beeinflussungen anderer Logikschaltungen in dem System führen kann. Daher werden üblicherweise Glättungs- und Siebungskondensatoren über die Spannungsversorgungsleitungen der Logikschaltungen geschaltet, um die Spannungsversorgung verschiedener Logikschaltungen nach Möglichkeit voneinander wechselspannungsmäßig zu entkoppeln.

Ein niedriger (dynamischer) Innenwiderstand des verwendeten Netzteileinschubs ist zudem günstig, um die Spannungsversorgung der verwendeten Logikschaltungen voneinander zu entkoppeln. Hierzu werden bei dem bekannten Stand der Technik entsprechend dimensionierte Elektrolytkondensatoren in dem Netzteil-Einschub verwendet, und der Anschluß des Motherboards an den Netzteileinschub erfolgt über Leitungen, die zur Verminderung des Innenwiderstands teilweise, nämlich für die Spannungsversorgung von +5V und Masse, mehrfach ausgebildet sind.

Die Verwendung von Mehrfachleitungen zur Verminderung des Innenwiderstands weist jedoch verschiedene Nachteile auf.

Zum anderen steigen die Kosten für die Bereitstellung der Leitungen nahezu linear mit der Anzahl der Leitungen an. Zum anderen können sich leicht verdeckte Fehler einschleichen. Wenn nämlich ein Anschluß der parallelgeschalteten Leitungen defekt oder zumindest zeitweise defekt ist, ermittelt eine statische Messung stets dennoch das ausreichende Versorgungsspannungspotential, da dieses durch die weiteren, parallelgeschalteten Leitungen bereitgestellt wird. Die Schwierigkeit der Fehlersuche steigt mit der Anzahl der parallelgeschalteten Leitungen an. Im Grunde muß dann jede Leitungen isoliert und von den weiteren Leitungen isoliert gemessen werden, um den bestehenden Fehler zu lokalisieren.

Andererseits ist es an sich bekannt, Netzgeräte über Stecker, an die je diskrete Einzelleitungen angeschlossen sind, mit einem Motherboard zu verbinden. Hierbei können auch sog. Sense- oder Meßleitungen als je diskrete Leitungen auf dem Motherboard angesteckt sein, so daß die vom Netzteil abgegebenen Spannungen zu dem Netzteil rückgekoppelt werden und somit der Ohm'sche Widerstand der Leitungen und der Anschluß-Steckverbindungen in den Regelkreis zur Spannungskonstanthaltung im Netzteil einbezogen werden können.

Diese vorgeschlagene Lösung hat sich jedoch als unpraktikabel erwiesen. Zum einen hat man die Anschlußstecker der Meßleitungen zum Zwecke der leichteren Erreichbarkeit in dem häufig beengten Computer-Gehäuse ziemlich am Rand des Motherboards angeordnet. Zum anderen unterblieb das Anschließen der vorbereiteten Meßleitungen doch vergleichsweise häufig, insbesondere, wenn der Computer auch ohne diese Leitungen, wenn auch nicht allzu zuverlässig, arbeitete. Schließlich waren die hiermit verursachten Fehler häufig schwierig zu finden und wurden teilweise einem sog. "Soft-error" zugeschrieben. Daher ist man von dieser Lösung abgegangen, so daß heute üblicherweise eine Mehrzahl von Spannungsversorgungsleitungen, die parallelgeschaltet sind, oder wenige Spannungsversorgungsleitungen mit entsprechend vergrößertem Querschnitt, üblich sind, obwohl deren Nachteile erkannt sind und nach wie vor bestehen, und zwar sowohl bei den fest eingebauten Netzgeräten als auch bei den (austauschbaren) Netzteileinschüben.

Demgegenüber ist es Aufgabe der Erfindung, einen Einschubeinheitenträger gemäß dem Oberbegriff von Anspruch 1 zu schaffen, dessen Spannungsversorgung zuverlässig arbeitet und mit vergleichsweise geringem elektromechanischen Aufwand auskommt.

Diese Aufgabe wird erfindungsgemäß durch Anspruch 1 gelöst. Vorteilhafte Weiterbildungen ergeben sich aus den Unteransprüchen.

Mit den erfindungsgemäßen Maßnahmen läßt sich erstaunlich einfach und preisgünstig eine konstruktive Lösung bereitstellen, die den Anforderungen der Praxis an die Stabilisierung und Fehlertoleranz der Netzteileinschübe in vollem Umfange Rechnung trägt, ohne die Herstellungskosten besonders groß wären. Zwei Aspekte lassen sich besonders günstig ausnutzen: Zum einen steigert die Anzahl der Anschlußstecker einer Mehrfachsteckbuchse keineswegs linear die Herstellungskosten, sondern erheblich unterproportional. Zum anderen sind in den (sekundär-)geregelten Netzteileinschüben ohnehin Meßleitungen vorgesehen, die üblicherweise ziemlich am Ausgang des Netzteileinschubs angeordnet sind und für die Erfindung lediglich durch die Steckverbindung durchverbunden werden müssen, so daß eigentlich kein elektronischer Zusatzaufwand erforderlich ist.

Die Bereitstellung der - bezogen auf das Motherboard - mittig angeschlossenen Meßleitungen bietet folgende verschiedene Vorteile: Der Ohm'sche Widerstand der Leiterbahnschichten für die Spannungsversorungen wird betriebsgünstig in großem Umfange in die Regelstrecke einbezogen. Dies wird dadurch erreicht, daß die Anschlußlängen innerhalb der Leiterbahnschichten zu den äußersten Steckbuchsenleisten auf das jeweils erreichbare Minimum optimiert werden. Zum anderen können die Meßleitungen äußerst kurz, d.h. praktisch ohne separate Kabel, gehalten sein, was das Einstreuen von externen Störungen vermindert.

Bei dem zuvor erläuterten Vorschlag, der sich nicht durchgesetzt hatte, waren die Meßleitungen versuchsweise auch einmal als Koaxialleitungen ausgeführt, um das Einstreuen von Störungen zu verhindern.

Man kann einfach die vorhandenen Mehrfach-Flachsteckverbindungen der Netzteileinschübe zur Mitte des Motherboards hin um ein Polpaar erweitern, sollten nicht ohnehin noch freie Steckverbindungen innerhalb der Mehrfachsteckverbindungen bestehen. Besonders günstig ist es auch, wenn bei den vorhandenen Mehrfachleitungen ohne Schaltungsänderung auf dem Motherboard das der Mitte des Motherboards nächstliegende Polpaar lediglich auf Seiten des Netzteil-Einschubs durch ein Umklemmen des entsprechenden Leitungspaars als Meßleitung verwendet wird.

Weitere Vorteile der erfindungsgemäßen Lösung lassen sich daraus ableiten, daß durch die Anbringung der mittigen Meßkontakte auf der Steckverbinderleiste des Netzteil-Einschubs ein sicherer Anschluß unabhängig von beengten räumlichen Verhältnissen im Rechnerinneren gewährleistet ist. Ferner erfolgt der Anschluß stets automatisch, sobald nur der Netzteil-Einschub eingesteckt ist, so daß bislang auftretende Bedienerfehler ausgeschaltet sind.

Die in den Unteransprüchen angegebenen Merkmale erlauben einen elektrisch besonders günstigen Anschluß des Netzteil-Einschubs.

Weitere Vorteile, Einzelheiten und Merkmale der Erfindung sind in der nachstehenden Beschreibung eines Ausführungsbeispiels anhand der Zeichnung näher erläutert.

Es zeigen:
- Fig. 1: eine schematische Darstellung eines Motherboards eines erfindungsgemäßen Einschubeinheitenträgers, wobei der erfindungsgemäße Einschubeinheitenträger zusätzlich gestrichelt perspektivisch dargestellt ist;
- Fig. 2: eine schematische Ansicht eines Spannungsversorgungs-Layers des Motherboards gemäß Fig. 1;
- Fig. 3: ein Schaltkreisdiagramm eines an sich bekannten Netzteils eines Netzteileinschubs mit mehreren Spannungs- und Masseversorgungsleitungen für den Anschluß an den Steckverbinder gemäß Fig. 1; und
- Fig. 4: eine schematische Ansicht der Abwandlung des Schaltbilds gemäß Fig. 3 zur Verwendung in einem erfindungsgemäßen Einschubeinheitenträger.

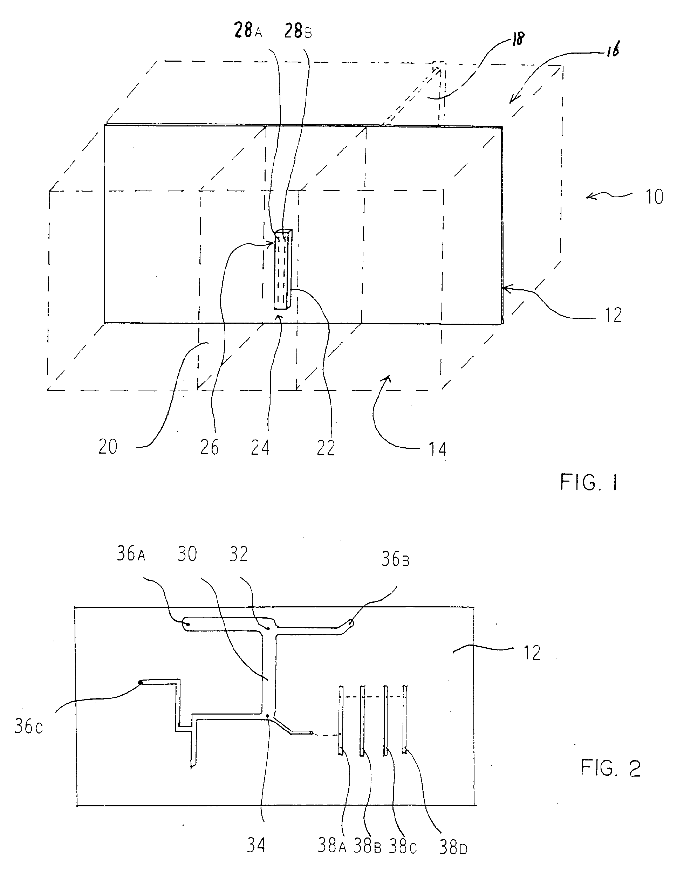

Ein erfindungsgemäßer Einschubeinheitenträger 10 weist eine Mutterplatine oder ein Motherboard 12 auf, das eine Netzteilseite 14 des Einschubeinheitenträgers 10 von einer Vorderseite 16 des Einschubeinheitenträgers 10 trennt. Das Motherboard 12 stellt einen Systembus für eine Mehrzahl von Einschubeinheiten, von denen eine Einschubeinheit 18 auf der Vorderseite in Fig. 1 gestrichelt dargestellt ist, bereit.

Auf der Netzteilseite 14 des Motherboards 12 ist ein Netzteil=Einschub 20 in den Einschubeinheitenträger 10 eingeführt, der über eine Steckverbindung 22 mit dem Motherboard 12 elektrisch und mechanisch verbunden ist. Von der Steckverbindung 22 ist in Fig. 1 eine zweireihige Messerkontaktleiste 24 dargestellt, die in an sich bekannter Weise auf dem Motherboard angebracht ist und in welche entsprechende Mehrfachstecker des Netzteil-Einschubs 20 einsteckbar sind.

In dem dargestellten Ausführungsbeispiel ist die Steckverbindung 22 in horizontaler Richtung nicht genau, jedoch etwa in der Mitte des Motherboards 12 vorgesehen und erstreckt sich in vertikaler Richtung. Dementsprechend ist ein Teil 26 der Steckverbindung 22 etwa in der Mitte des Motherboards 12 angeschlossen. Dieser Teil 26 weist zwei Messerkontakte 28a und 28b auf.

Wie es weiter unten dargestellt ist, werden die Messerkontakte 28a und 28b für den Anschluß der Meßleitungen verwendet.

Auch wenn nicht exakt die Mitte des Motherboard 12 von den Messerkontakten 28a und 28b abgedeckt ist, so sind diese doch zumindest innerhalb der Steckverbindung 22 der Mitte des Motherboards 12 am nächsten. Es versteht sich, daß die Mitte des Motherboards 12 durch die elektrischen Gegebenheiten bestimmt ist, so daß möglichst der gesamte, durch die verschiedenen Einschubeinheiten 18 erzeugte Spannungsabfall auf den Spannungsversorgungsleitungen innerhalb des Motherboards 12 mit den Messerkontakten 28a und 28b erfaßt wird.

Wenn, wie es in Fig. 1 dargestellt ist, die Einschubeinheiten senkrecht nebeneinander in den Einschubeinheitenträger 10 einsteckbar sind, ist es günstig, wenn sowohl die Spannungsversorgung etwa in der horizontalen Mitte, bezogen auf die Steckplätze für die Einschubeinheiten 18, als auch die Erfassung der Spannung über die Meßleitungen dort, aber beabstandet von der Spannungsversorgung, erfolgt. Die durch die Leiterbahnen auf dem Motherboard 12 erzeugten Spannungsabfälle sind dann minimiert, auch wenn ungünstige Betriebszustände vorliegen, wie das Einstecken der stärksten stromverbrauchenden Einschubeinheiten 18 an den äußersten Steckplätzen.

In einem Ausführungsbeispiel, das eine Änderung des Motherboards 12 erfordert, ist es vorgesehen, einen (geringen) Teil der Leiterbahnen für die Spannungsversorgung auf dem Motherboard 12 abzutrennen und für den Anschluß der Meßleitungen bereitzustellen, so daß auch die Spannungserfassung je an dem Steckbuchsen für die Einschubeinheiten 18 erfolgen kann.

Auch wenn in dem dargestellten Ausführungsbeispiel in Fig. 1 nur eine Einschubeinheit 18 auf der Vorderseite 16 des Motherboards 12 dargestellt ist, versteht es sich, daß weitere Einschubeinheiten auf der Netzteilseite 14 neben dem Netzteil-Einschub 20 eingesteckt werden können. Gemäß einer weiteren Ausführungsform können Vorderseite 16 und Netzteilseite 14 auch zusammenfallen. Das Motherboard 12 kann in bekannter Weise mehrlagig in der sog. Multilayertechnik ausgebildet sein, so daß eine Schicht als Masseschicht ausgebildet ist und eine weitere Schicht als Spannungsversorgungsschicht, beispielsweise mit dem Potential +5V, ausgebildet ist.

Einer der Messerkontakte 28a ist dann an einer günstigen Stelle mit der Masseschicht, und der Messerkontakt 28b an einer entsprechenden Stelle mit der Spannungsversorgungsschicht verbunden.

Es kann auch günstig sein, die normalerweise sehr breiten Spannungsversorgungs-Leiterbahnen aufgeschlitzt vorzusehen, so daß ein sehr schmaler Teil als Verlängerung der Meßleitung unmittelbar zu den Stromsenken geführt ist.

In Fig. 2 ist ein beispielhafter Leiterbahn-Aufbau vereinfacht dargestellt. Über die Steckverbindung 22 ist eine Stromversorgungs-Leiterbahn 30 bei dem Anschlußpunkt 32 an eine Spannungsquelle des Netzteileinschubs 20 gemäß Fig. 1 angeschlossen. An einem weiteren Anschlußpunkt 34, der auf der Leiterbahn 30 etwas von dem Anschlußpunkt 32 entfernt ist, ist eine in Fig. 2 nicht dargestellte Meßleitung über den Messerkontakt 28a gemäß Fig. 1 angeschlossen. Die Leiterbahn 30 verbindet ferner verschiedene Anschlußpunkte 36a bis 36c sowie weitere, nicht dargestellte Anschlußpunkte, die je an Stromsenken angeschlossen sind.

Galvanisch mit der Stromversorgungs-Leiterbahn 30 verbunden sind Busleitungen 38a bis 38d, wobei der Anschluß je über Drahtbrücken oder über durchkontaktiert angeschlossene Leiterbahnen in einer anderen Schicht des Multilayer-Motherboards 12 erfolgt. Die Busleitungen 38a bis 38d dienen je zur Spannungsversorgung der Anschlußstecker für die Einschubeinheiten 18, die in den Einschubeinheitenträger 10 eingesteckt werden können.

Bei Belastung der Stromversorgung durch eine Stromsenke an einem der Anschlußpunkte 36a bis 36c bzw. der Busleitungen 38a bis 38d entsteht nun in der Stromversorgungs-Leiterbahn 30 ein, wenn auch geringer, Spannungsabfall zwischen dem Anschlußpunkt 32 und der jeweiligen Stromsenke. Durch die mittige Anordnung des Anschlußpunkts 34 für die Meßleitung, beabstandet von dem Anschlußpunkt 32, wird der durch die Stromsenken erzeugte Spannungsabfall in der Stromversorgungs-Leiterbahn 30 in den Regelkreis des Netzteileinschubs 20 einbezogen und damit ausgeregelt.

Hierbei läßt sich günstigerweise die Tatsache ausnutzen, daß bei entsprechender Belastung mit den Stromsenken das Leiterbahn-Teilstück zwischen den Anschlußpunkten 36a und 32, sowie 36b und 32, sowie 34 und 32 je den etwa gleichen Spannungsabfall zeigt, so daß der erwähnte erwünschte Effekt der mittigen Anordnung sich hierdurch einstellt.

In Fig. 2 ist eine entsprechende Ausbildung lediglich für die Spannungsversorgungs-Leiterschicht dargestellt. Selbstverständlich ist es möglich, eine entsprechende Ausführung der Masseschicht innerhalb des Multilayer-Motherboards 12 vorzusehen und einen für die Meßleitungen günstigen Anschlußpunkt zu wählen. In vielen Fällen wird jedoch die Masseschicht nahezu vollflächig in dem Motherboard 12 vorgesehen sein, so daß eine beabstandete Anordnung zwischen dem Anschlußpunkt für die Meßleitung und dem Anschlußpunkt für die Stromquelle entbehrlich ist.

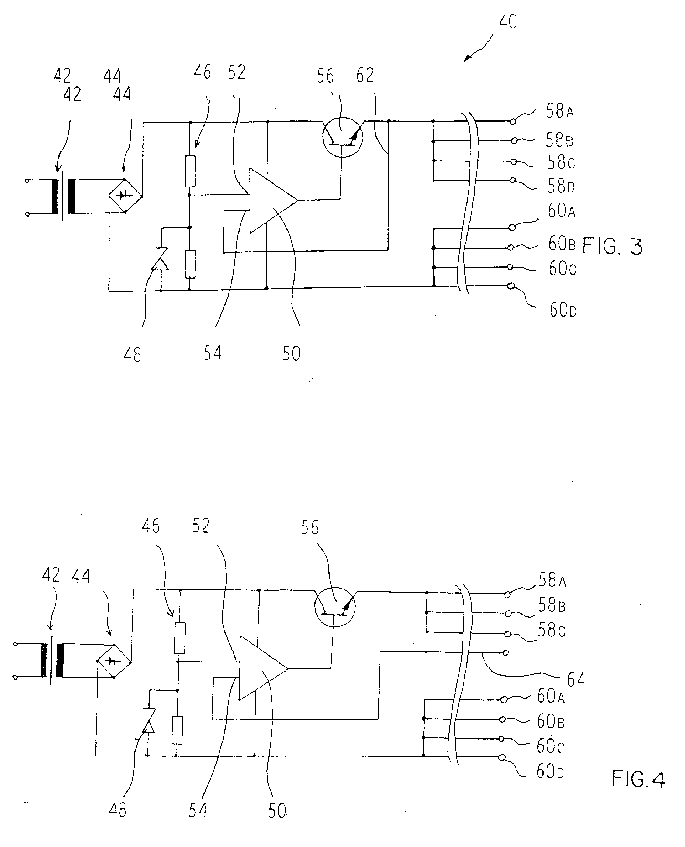

Anhand der Figuren 3 und 4 wird eine Schaltungsänderung eines handelsüblichen Netzteils 40 in Längsregeltechnik gezeigt, wobei die Schaltungsänderung sich wiederum nur auf einen Anschluß bezieht, jedoch ohne weiteres bei Masse und ggf. bei weiteren Potentialausgängen des Netzteils entsprechend vorgenommen werden kann. Selbstverständlich ist eine entsprechende Schaltungsänderung auch bei einem Netzteil 40 in primär- oder sekundärgetakteter Schalttechnik möglich, wenn eine entsprechende Sense-Leitung verwendet oder nachgerüstet werden kann.

Das in Fig. 3 dargestellte Netzteil weist in bekannter Weise einen Transformator 42, einen an diesen angeschalteten Gleichrichter 44, einen an den Ausgang des Gleichrichters 44 angeschlossenen, nicht dargestellten Kondensator, einen parallel hierzu geschalteten Spannungsteiler 46 mit einer Referenzspannungsquelle 48, sowie einen Regelverstärker 50 auf, der zwei Differenzeingänge 52 und 54 und einen Ausgang aufweist, der an einen Längsregel-Transistor 56 angeschlossen ist.

In der Darstellung gemäß Fig. 3 ist bei dem üblichen Netzteil 40 der Ausgang des Längsregel-Transistors 56 sowohl mit einem Eingang 54 des Regelverstärkers 50, der als Differenzverstärker ausgebildet ist, als auch mit Ausgangsklemmen 58a bis 58d verbunden, die je über entsprechende Leitungen mit der Steckverbindung 22 gemäß Fig. 1 verbunden sind. Durch diese Verbindung wird das Netzteil geregelt und die Ausgangsspannung, beispielsweise bei +5V, konstant gehalten.

Entsprechend den Ausgangsanschlüssen 58a bis 58d sind masseseitig Ausgangsanschlüsse 60a bis 60d vorgesehen, die über entsprechende Leitungen ebenfalls mit der Mehrfach-Steckverbindung 22 verbunden sind.

Während die Leitung 62 zwischen dem Ausgang des Transistors 56 und dem Eingang 54 des Regelverstärkers 50 ziemlich dünn bemessen ist, sind bei dem bekannten Netzteil 40 die Leitungen an den Ausgangsanschlüssen 58 und 60, sowie auch die entsprechende Steckverbindung 22, mehrfach und mit ziemlich großem Querschnitt realisiert, um den dort auftretenden Spannungsabfall zu verringern.

Andererseits zeigen Steckverbindungen bei häufigerem Betätigen eine Zunahme des Übergangswiderstandes, wenn nicht die vergleichsweise teuren Goldkontakte verwendet werden.

Mit dem erfindungsgemäßen Einschubeinheitenträger lassen sich durch eine sehr einfache Änderung die vorstehend aufgeführten Nachteile der bekannten Einschubeinheitenträger vermeiden. Die Leitung 62 wird hierzu von dem Ausgang des Transistors 56 getrennt und mit dem Ausgangsanschluß 58d verbunden, dessen galvanische Verbindung mit den übrigen Ausgangsanschlüssen 58a bis 58c ebenfalls unterbrochen wird. Hierdurch wird die Leitung 62 zur Meßleitung 64. Bereits durch diese Maßnahme wird überraschend die in der Praxis bestimmende Stabilität der Spannungsversorgung erheblich besser. Die in Fig. 4 dargestellte Schaltungsänderung kann dementsprechend auch nachträglich erfolgen, so daß die bei den bekannten Geräten bestehenden Probleme mit zu instabilen Spannungen mit geringem Aufwand beseitigt werden können.

Selbstverständlich kann bei den Ausgangsanschlüssen 60a bis 60d entsprechend verfahren werden, und eine Masse-Meßleitung kann direkt zur Referenzspannungsquelle 48 geführt werden.

Die Einstellung der gewünschten Ausgangsspannung in dem Netzteil 40 kann dann zweckmäßigerweise nach folgendem Schema erfolgen: Es wird der maximale Spannungsabfall zwischen den äußersten Stromsenken auf dem Motherboard 12 und dem Anschlußpunkt 34 gemessen oder berechnet, der im ungünstigsten Betriebsfall auftritt. Um diesen Spannungsabfall wird die Sollwert-Einstellung an der Referenzspannungsquelle 48 erhöht, so daß der auch bei den näher der Mitte angeordneten Einschubeinheiten 18 auftretende Spannungsabfall, unabhängig von der Bestückung des Einschubeinheitenträgers, stets innerhalb dieses Limits, und damit innerhalb der erlaubten Grenzen, bleibt.

In einer Abwandlung des erfindungsgemäßen Einschubeinheitenträgers ist es vorgesehen, die Meßleitung 64 oder eine weitere, separat aus dem Netzteil 40 herausgeführte Meßleitung zugleich als Schaltleitung zu verwenden, die, beispielsweise softwaregesteuert, in der Lage ist, das Netzteil 40 komplett abzuschalten, beispielsweise, wenn die Betriebstemperatur des Einschubeinheitenträgers die erlaubten Werte überschreitet. Dann kann diese Meßleitung als Busleitung für die Steckplätze der Einschubeinheiten 18 ausgelegt sein, um so die Möglichkeit einer beliebigen interruptgesteuerten Vollabschaltung des Computers zu eröffnen.

Besonders günstig zur Bereitstellung eines derartigen Abschaltsignales ist es, wenn das Abschalten auch softwaregesteuert erfolgen kann, indem beispielsweise eine bestimmte Speicherstelle im I/O-Adreßraum des Computers für die Abschaltung reserviert wird, wobei das Schreiben einer bestimmten Information in diese Speicherstelle durch eine entsprechende Decodierung erfaßt wird, die dann das Abschaltsignal weiterleitet.

Ein besonderer Aspekt, aus dem sich in der Praxis erhebliche Vorteile ziehen lassen, ist die Verwendung eines kompakten Netzteil-Einschubs, ohne zusätzliche und separat zu steckende Signalverbindung.

Wenn eine Leerlauffestigkeit des in Fig. 4 dargetellten Netzteils 40 gewünscht ist, kann dies auf einfache Weise durch Verschaltung einer entsprechend gepolten Diode zwischen der Leitung 62 und dem Ausgang des Transistors 56 erreicht werden.

## Patentansprüche

1. Einschubeinheitenträger (10), mit einer Vorderseite (16) versehen mit Einschubeinheiten-Steckplätze, über welche eine Mehrzahl von Einschubeinheiten (18), insbesondere Steckkarten, Hintergrund-Speichermedien und Zubehör, in dem Einschubeinheitenträger unter elektrisch sicherer Kontaktgabe einsteckbar sind, und mit einer Netzteilseite (14), über welche ein Netzteil-Einschub (20) in den Einschubeinheitenträger (10) ebenfalls unter elektrisch sicherer Kontaktgabe einschiebbar ist, wobei die Einschubeinheiten (18) und der Netzteil-Einschub (20) über eine Mutterplatine (12) mechanisch und elektrisch miteinander verbindbar sind und wobei eine Steckverbindung (22) die Spannungsversorgung der Einschubeinheiten (18) und die elektrische Verbindung zwischen dem Netzteil-Einschub (20) und der Mutterplatine (12) herstellt, dadurch **gekennzeichnet**, daß mindestens ein eine Mehrfachsteckbuchse aufweisender Teil (26) der Steckverbindung (22) im wesentlichen mittig, bezogen auf die Steckplätze für die Einschubeinheiten (18), auf der Mutterplatine (12) angeordnet ist, welcher Teil (26) zwei Meßkontakte (28a, 28b) zur Erfassung eines durch die Einschubeinheiten (18) auf den Spannungsversorgungsleitungen der Mutterplatine (12) erzeugten Spannungsabfalls und zur Rückkopplung dieses über Meßleitungen (64) in den Netzteileinschub (20) aufweist.

2. Einschubeinheitenträger nach Anspruch 1, dadurch gekennzeichnet, daß die Mutterplatine (12) in Multilayertechnik ausgebildet ist und eine erste Spannungsversorgungsschicht (30) und eine Masseschicht aufweist und daß die Meßkontakte (28a, 28b) für die Meßleitungen (64) im wesentlichen im Flächenschwerpunkt dieser Schichten angeordnet sind.

3. Einschubeinheitenträger nach einem der vorhergehenden Ansprüche, dadurch gekennzeichnet, daß insbesondere bei nichtzentraler Anordnung des Spannungsversorgungsanschlusses (32) der Steckverbindung (22), bezogen auf die Mutterplatine (12), die Meßkontakte für die Meßleitungen (64) im wesentlichen in der Mitte der Strecke zwischen dem äußersten Steckplatz auf der Mutterplatine (12) auf der von dem Spannungsversorgungsanschluß (32) abgewandten Seite und dem Spannungsanschluß (32) angeordnet sind.

4. Einschubeinheitenträger nach einem der vorhergehenden Ansprüche versehen mit dem Netzteil-Einschub (20), welcher ein Netzteil (40) umfaßt, dadurch gekennzeichnet, daß mit einem in einem Netzteil (40) angeordneten Stellglied für die Sollwerteinstellung die gewünschte Spannung in dem Netzteil-Einschub (20) so einstellbar ist, daß dem Spannungsversorgungsanschluß (32) der Steckverbindung (22) unmittelbar benachbarte Einschubeinheiten-Steckplätze eine Spannung aufweisen, die die Sollwertspannung etwa um den gleichen Betrag übersteigen, um den die Spannungen an den von dem Spannungsversorgungsanschluß (32) am entferntesten angeordneten Einschubeinheiten-Steckplätzen unterhalb dieses Sollwerts liegen.

5. Einschubeinheitenträger nach Anspruch 1, dadurch gekennzeichnet, daß ein weiterer Kontakt für eine Steuerleitung in der Steckverbindung (22) vorgesehen ist, mit welchem in Abhängigkeit von einem über eine Decodierung erfaßten Zustand auf einer der Einschubeinheiten (18) über die Steuerleitung der Netzteil-Einschub (20) abschaltbar ist.

## Claims

1. Slide-in unit carrier (10) with a front side (16) provided with slide-in unit plug-in locations, via which several slide-in units (18), in particular plug-in cards, background storage media and accessories, can be inserted in the slide-in unit carrier with electrically safe contact-making, and with a power pack side (14), via which a power pack slide-in unit (20) can likewise be pushed into the slide-in unit carrier (10) with electrically safe contact-making, whereby the slide-in units (18) and power pack slide-in unit (20) can be connected mechanically and electrically to each other via a motherboard (12) and whereby a plug-in connection (22) establishes the voltage supply of the slide-in units (18) and the electrical connection between the power pack slide-in unit (20) and the motherboard (12), **characterised in** that at least one part (26) with a multiple socket of the plug-in connection (22) is arranged essentially centrally in relation to the plug-in locations for the slide-in units (18) on the motherboard (12), said part (26) having two measuring contacts (28a, 28b) for measurement of a voltage drop produced by the slide-in units (18) on the voltage supply lines of the motherboard (12) and for feedback of this voltage drop via measuring lines (64) to the power pack slide-in unit (20).

2. Slide-in unit carrier according to claim 1, **characterised in** that the motherboard (12) is constructed on the multilayer principle and has a first voltage supply layer (30) and an earthing layer and that the measuring contacts (28a, 28b) for the measuring lines (64) are arranged essentially in the centre of the area of these layers.

3. Slide-in unit carrier according to one of the preceding claims, characterised in that in particular when the voltage supply connection (32) of the plug-in connection (22) is not arranged centrally in relation to the motherboard (12) the measuring contacts for the measuring lines (64) are arranged essentially in the centre of the section between the outermost plug-in location on the motherboard (12) on the side facing away from the voltage supply connection (32) and the voltage connection (32).

4. Slide-in unit carrier according to one of the preceding claims provided with the power pack slide-in unit (20), which comprises a power pack (40), characterised in that the required voltage in the power pack slide-in unit (20) can be adjusted by a control element arranged in a power pack (40) for adjustment of the required value in such a way that slide-in unit locations immediately adjacent to the voltage supply connection (32) of the plug-in connection (22) have a voltage which exceeds the required voltage by about the same amount by which the voltages at the slide-in unit plug-in locations most distant from the voltage supply connection (32) are below this required value.

5. Slide-in unit carrier according to claim 1, **characterised in** that a further contact for a control line, with which the power pack slide-in unit (20) can be switched off as a function of a condition measured via decoding on one of the slide-in units (18) by the control line, is provided in the plug-in connection (22).

## Revendications

1. Support d'unités de tiroir (10), avec un côté antérieur (16) pourvu d'emplacements d'insertion d'unités de tiroir, sur lequel une pluralité d'unités de tiroir (18), en particulier des cartes à insérer, des supports d'enregistrement de fond et des accessoires, peuvent être introduits dans le support d'unités de tiroir avec établissement d'un contact électrique sûr, et avec un côté d'alimentation sur le réseau du secteur (14), sur lequel un tiroir d'alimentation réseau (20) peut être introduit dans le support d'unités de tiroir (10) également avec établissement d'un contact électrique sûr, les unités de tiroir (18) et le tiroir d'alimentation réseau (20) pouvant être reliés mécaniquement et électriquement entre eux par une carte-mère (12) et une connexion (22) établissant l'alimentation en tension des unités de tiroir (18) et le raccordement électrique entre le tiroir d'alimentation réseau (20) et la carte-mère (12), caractérisé en ce qu'au moins une partie (26) de la connexion (22) présentant un connecteur multiple femelle est disposée sensiblement au centre, par rapport aux emplacements des unités de tiroir (18), sur la carte-mère (12) , laquelle partie (26) présente deux contacts de mesure (28a, 28b) pour la détection d'une perte de tension produite par les unités de tiroir (18) sur les lignes d'alimentation de la carte-mère (12) et pour le retour de celle-ci par des lignes de mesure (64) dans le tiroir d'alimentation réseau (20).

2. Support d'unités de tiroir selon la revendication 1, caractérisé en ce que la carte-mère (12) est conçue selon la technique multicouche et présente une première couche d'alimentation (30) et une couche de masse et en ce que les contacts de mesure (28a, 28b) pour les lignes de mesure (64) sont disposés sensiblement au centre de gravité de la surface de ces couches.

3. Support d'unités de tiroir selon l'une ou l'ensemble des revendications précédentes, caractérisé en ce qu'en particulier avec une disposition non centrale du raccord d'alimentation (32) de la connexion (22), par rapport à la carte-mère (12), les contacts de mesure pour les lignes de mesure (64) sont disposés sensiblement au milieu du trajet entre l'emplacement de connexion le plus extérieur sur la carte-mère (12) du côté opposé au raccord d'alimentation (32) et le raccord d'alimentation (32).

4. Support d'unités de tiroir selon l'une ou l'ensemble des revendications précédentes, pourvu du tiroir d'alimentation réseau (20), qui comprend une partie d'alimentation réseau (40), caractérisé en ce qu'avec un organe de réglage disposé dans une partie d'alimentation réseau (40), pour l'établissement de la valeur nominale, la tension souhaitée peut être réglée dans le tiroir d'alimentation réseau (20) de telle sorte que les emplacements de connexion d'unités de tiroir directement voisins du raccord d'alimentation (32) présentent une tension qui dépasse la tension nominale approximativement de la même valeur que les tensions sur les emplacements de connexion d'unités de tiroir disposés le plus loin du raccord d'alimentation (32) sont inférieures à cette valeur nominale.

5. Support d'unités de tiroir selon la revendication 1, caractérisé en ce qu'un autre contact pour une ligne de commande est prévu dans la connexion (22) avec lequel, selon un état détecté par un décodage sur l'une des unités de tiroir (18), le tiroir d'alimentation réseau (20) peut être déconnecté par l'intermédiaire de la ligne de commande.
